# EUROPEAN PATENT APPLICATION

(11) **EP 4 215 732 A1**
(43) Date of publication of application: **26.07.2023**
(21) Application number: 23150149.5
(22) Date of filing: 03.01.2023
(51) Int. Cl.: F02C 7/00

(54) **COOLING DEVICE FOR POWER ELEMENTS OF TURBINE ENGINE CONTROL UNIT**

(30) Priority: 20.01.2022 CZ 20222600
(71) Applicant: Prvni brnenska strojirna Velka Bites, a.s., 595 01 Velka Bites (CZ)
(72) Inventor: Hubacek, Tomas, 59501 Velka Bites (CZ)
(74) Representative: Malusek, Jiri

(57) **Abstract**

Cooling device (1) for power elements of turbine engine control unit arranged in a housing (2) whereas on power elements (6) a circuit board (7) is arranged, whereas a part of the housing (2) is a closed fuel chamber (14) with a fuel pump (8) connected to the fuel tank (4) and to the electronic control unit, the closed fuel chamber (14) complements concerning shape with housing (2) and is separate, but is a part of the housing (2), where the cooling device (1) is mounted in a box (15) arranged outside the housing (2), and defined by a mounting board (12) which is a part of the housing (2), and by walls (10'), and a cover (10), and the cooling device (1) is formed by ribs (9) as cooling elements which are arranged on the mounting board (12) inside of the box (15), whereas power elements of the control unit (5) are arranged on the mounting board (12) inwards the housing (2) and a space is provided along the ribs (9) in the box (15) for passage of fuel for cooling power elements (6) of the control unit (5).

## Description

### Technical field

The invention relates to cooling power electronics for controlling a turbine engine.

### Background of the invention

The power electronics of a turbine engine control system and power electronics of the converter to supply electrical power to the aircraft board are generally cooled by suction air. When operating at high flight speed conditions, where the Mach number is above 0.5, particularly in hot climates, there is not sufficient difference between the suction air temperature and the surface temperature of power electronics components to provide cooling of power electronics components. This can lead to performance limitation of power electronics. Cooling is required by power elements, the MOSFET type transistors of the power electronics converter and the fuel pump driver.

In addition, the fuel pump of a turbine engine is in the case of mechanical supply usually located on the reducer or it is driven directly from the rotor shaft. In the case of electric drive, the pump is usually connected to the control electronics by cables and connectors. The electric pump and the interconnecting wiring must then be protected against the effects of ambient influences such as interference and to prevent unacceptable radiation to the enviroment.

The aim of the invention is to provide a cooling device for power elements of turbine engine control unit and a power converter, which would provide efficient cooling while eliminating the aforementioned deficiencies of the fuel pump without the need for shielding, while limiting electromagnetic radiation to the environment.

### Summary of the invention

The above mentioned deficiencies are eliminated by a cooling device for power elements of turbine engine control unit according to the invention, which is characterised by the fact that the cooling device is mounted in a box arranged outside the housing, and defined by a mounting board which is a part of the housing, and by walls, and a cover, and the cooling device is formed by ribs as cooling elements which are arranged on the mounting board inside of the box, whereas power elements of the control unit are arranged on the mounting board inwards the housing and a space is provided along the ribs in the box for passage of fuel for cooling power elements of the control unit.

In a preferred embodiment on the inner surface of the mounting board a heat distribution board is arranged to increase heat dissipation from the power elements arranged thereon, and on power elements the circuit board is arranged.

### Brief description of drawings

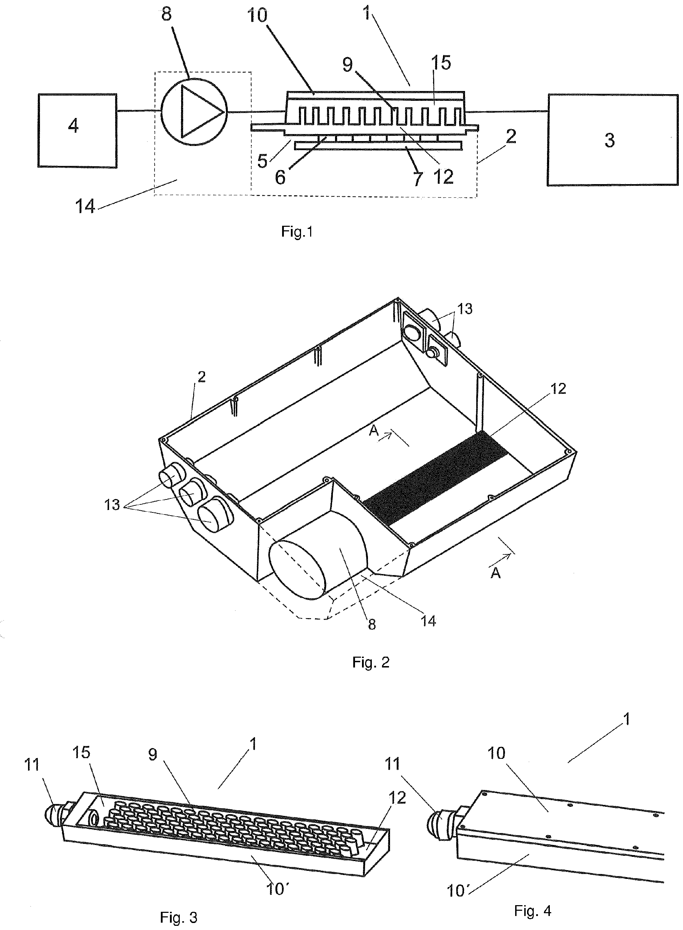

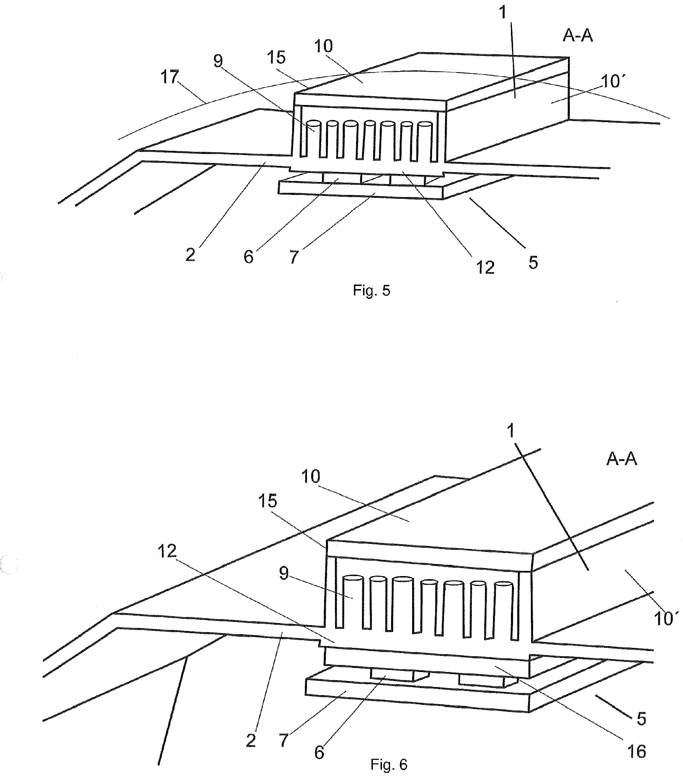

The invention will be further explained by means of drawings, in which Fig. 1 is a schematic view of a part of a turbine engine with a cooling device according to the invention, Fig. 2 is an interior view of an uncovered box, Fig. 3 is a perspective top view of a detail of a cooling device with an uncovered box, Fig. 4 is a perspective top view of a detail of the cooling device covered by the box, Fig. 5 is a perspective view of a section through the cooling device along line A-A of Fig. 2, and Fig. 6 is a perspective view of a section through the cooling device with the distribution board along line A-A of Fig. 2.

### Detailed description of the invention

Fig. 1 is a schematic view of a part of a turbine engine with a cooling device according to the invention arranged within a housing 2, here indicated by a dashed rectangle, in a manner to be commented later. Connected to the housing 2 is a pump 8 in a closed fuel chamber 14, which will be discussed later. The fuel pump 8 is connected to a fuel tank 4 and to an electronic control unit 5, which is known in the branch as an ECU. The cooling device 1 is provided for cooling the electronic control unit 5.

As can be seen in Fig. 2, the electronic control unit 5 is arranged on a mounting board 12 which is part of the housing 2, facing inwardly into the housing 2, while the cooling device 1 is arranged on the mounting board 12 facing inwardly into the box 15, thus in the box 15, which is defined, in addition to the mounting board 12, by walls 10' and a cover 10 whereas the box 15 is arranged outside the housing 2. This will be discussed in detail in the description of Figs. 5 and 6. The position of the mounting board 12 within the housing is also shown in Fig. 2.

It can be seen that the pump 8 is arranged in an a closed fuel chamber 14, which complements concerning shape the housing 2 and which is separate, but is a part of the housing 2.

On the sides of the housing 2 connectors 13 for connecting the wiring are arranged, that is, for connection to the supply voltage from the unshown battery, the output from the converter, the connection of the starter-generator, the connection of the sensors from the engine 3. By integrating the fuel chamber 14 with the pump 8 into the housing 2, external wiring with connectors is eliminated, and at the same time, the interference induced on the wires is avoided and it is not necessary to use interference filters on connectors, i.e. shielding.

In addition, in the housing 2 control electronics of the engine 3, us integrated i.e. its control unit 5. The housing 2 also contains a not shown BLDC drive of fuel pump, which is a brushless DC motor, and an unshown AC/DC power converter, which supplies electrical power to the aircraft board, eventually electric fuel valve.

Inwards of the housing 2, on the mounting board 12, the electronic control unit 5 is arranged, which includes power elements 6 and a circuit board 7 arranged thereon.

In the second embodiment in Fig. 6, a heat distribution board 16 is arranged between the power elements 6 and the mounting board 12 to increase heat dissipation from the power elements 6 arranged thereon, and on power elements 6 the circuit board 7 is arranged.

In Fig. 3 and 4, it can be seen that into the box 15 with ribs 9 arranged therein fuel is fed along the ribs 9 from the fuel pump 8 via an inlet 11, whereas the fuel pump 8 is connected to the fuel tank 4. From the box 15, the fuel is then led to a not shown regulator located on the engine 3. From there, the fuel is fed to a not shown engine fuel ramp which distributes the fuel to not shown fuel nozzles. The ribs 9 may be part of the housing 2 or suitably attached thereto.

Fig. 3 is a perspective top view of a detail of the box 15 of the cooling device 1 with the cover removed. It can be seen that in addition to the cover 10, the box 15 is formed by walls 10' and by the aforementioned mounting board 12. The inlet 11 for the fuel from the pump 8 can be seen here. Furthermore, the arrangement of the ribs 9 can be seen.

Fig. 4 also shows a perspective top view of the cooling device 1 covered by the cover 10 and by the side walls 10'.

Fig. 5 is a perspective detail view of a section of the cooling device 1 with the electronic control unit 5 along the line A-A of Fig. 2 in the first embodiment. The housing 2 is arranged in the engine body. The perimeter of mentioned engine body is schematically indicated by the referrence sign 17. It can be seen that the housing 2 includes the mounting board 12. Inwards of the housing 2, on the mounting board 12 power elements 6 are arranged and a circuit board 7 is arranged thereon. Inwards the box 15, on the mounting board 12, ribs 9 as cooling elements are arranged and a space is provided among the ribs 9 in the box 15 for passage of fuel which enables cooling power elements 6 of the control unit 5. The fuel leaves the box 15 and flows to the controller arranged on the engine 3.

Fig. 6 is a perspective detail view of a section of the cooling device 1 with the electronic control unit along line A-A of Fig. 2 in the second embodiment. It can be seen that the housing 2 includes a mounting board 12, and inwards of the housing 2 on the mounting board 12 a distribution board 16 is arranged for increased heat dissipation from the power elements 6 arranged thereon, and only on the power elements 6 the circuit board 7 is arranged. The arrangement of the cooling device 1 is the same as in Fig. 5.

## Claims

1. Cooling device (1) for power elements of turbine engine control unit arranged in a housing (2) whereas on power elements (6) a circuit board (7) is arranged, whereas a part of the housing (2) is a closed fuel chamber (14) with a fuel pump (8) connected to the fuel tank (4) and to the electronic control unit, the closed fuel chamber (14) complements concerning shape with housing (2) and is separate, but is a part of the housing (2), **characterised in that** the cooling device (1) is mounted in a box (15) arranged outside the housing (2), and defined by a mounting board (12) which is a part of the housing (2), and by walls (10'), and a cover (10), and the cooling device (1) is formed by ribs (9) as cooling elements which are arranged on the mounting board (12) inside of the box (15), whereas power elements of the control unit (5) are arranged on the mounting board (12) inwards the housing (2) and a space is provided along the ribs (9) in the box (15) for passage of fuel for cooling power elements (6) of the control unit (5).

2. Cooling device according to claim 1, **characterized in that** on the inner surface of the mounting board (12) a heat distribution board (16) is arranged to increase heat dissipation from the power elements (6) arranged thereon, and on power elements (6) the circuit board (7) is arranged.
